# EUROPEAN PATENT APPLICATION

(11) **EP 0 847 092 A1**
(43) Date of publication of application: **10.06.1998**
(21) Application number: 97402922.5
(22) Date of filing: 03.12.1997
(51) Int. Cl.: H01L 39/14, C04B 35/46

(54) **Oxide insulator film having a layered structure.**

(30) Priority: 03.12.1996 JP 337573/96; 18.02.1997 JP 49706/97
(71) Applicant: SUMITOMO ELECTRIC INDUSTRIES, LIMITED, Osaka 541 (JP)
(72) Inventor: Nakamura Takao, 1-3 Shimaya 1-chome, Konohana-ku, Osaka (JP); Iiyama, Michitomo, 1-3 Shimaya 1-chome, Konohana-ku, Osaka (JP)
(74) Representative: Ballot, Paul Denis Jacques

(57) **Abstract**

The invention provides an oxide insulator film having a layered structure comprising at least two layers (32, 33) formed of oxide insulators having temperature properties different from each other. The insulator layers preferably comprise at least one ferroelectric layer.

## Description

### Background of the Invention

### Field of the invention

The present invention relates to an oxide insulator film having a layered structure, and more specifically to an oxide insulator film having properties suitable for combination with oxide superconductors.

### Description of related art

Oxide superconductors have been considered to have higher critical temperatures than those of metal superconductors, and therefore to have high possibility of practical use. For example, Y-Ba-Cu-O type oxide superconductor has a critical temperature higher than 80 K and it is reported that Bi-Sr-Ca-Cu-O type oxide superconductor and Tl-Ba-Ca-Cu-O type oxide superconductor have critical temperatures higher than 100 K.

In order to apply the oxide superconductor to superconducting electronic technology such as a superconducting device, a superconducting integrated circuit, it is necessary to form a thin film of oxide superconductor. In addition, for these applications of the oxide superconductor thin film, a film of an insulator having a lattice matching to the lattice of the oxide- superconductor and various temperature coefficients equal or similar to those of the oxide superconductor is necessary. The insulator film is used for a tunnel barrier layer, a gate insulator layer, an inter-layer insulator layer etc. of superconducting devices utilizing the oxide superconductor.

A ferroelectric such as SrTiO₃ (abbreviated to STO hereinafter) is used for the insulator film of the superconducting devices utilizing the oxide superconductor. STO has physical constants almost equal to those of the oxide superconductor and a film of STO can be deposited under conditions almost equal to conditions under which a film of oxide superconductor is deposited. Therefore, STO is preferable for the above insulator.

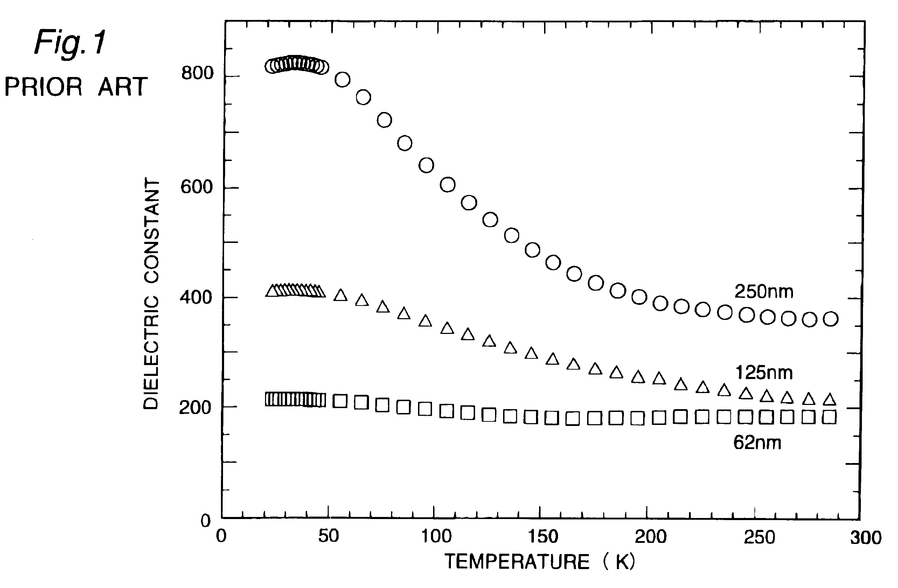

However, the ferroelectric has dielectric properties having large dependence on temperatures such that it has the greatest value of the dielectric constant at a specific temperature corresponding to constituent elements, and it considerably drops at another temperature. Figure 1 shows temperature dependence of dielectric constant (relative permittivity) of STO films having a thickness of 62 nanometers, 125 nanometers and 250 nanometers. As shown in Figure 1, the dielectric constant of the STO film having a thickness of 250 nanometers has the greatest value of 825 at a temperature of 35 K. However, it has a value of 300-400 at the room temperature. STO is liable to include oxygen defects which reduce its breakdown voltage.

There is a ferroelectric having the greatest value of the dielectric constant at a temperature near the room temperature and decreasing monotonically with temperature lowering.

The ferroelectric having properties dependent to temperature causes the following problems when it is used for the insulator mentioned above. If the ferroelectric having the dielectric constant dependent to temperature is used for an inter-layer insulator film of multi-layered wiring structure using the oxide superconductor, transmission rates of signals and transmission losses of the wiring may have temperature dependence similar to that of the dielectric constant. In particular, if the operating temperature of the multi-layered wiring structure is set to the temperature at which the dielectric constant of the ferroelectric has the greatest value, the temperature range where the multi-layered wiring structure conducts stable operations is very narrowed. If the multi-layered wiring structure is used at a temperature range where the dielectric constant of the ferroelectric has small temperature dependence, the properties of the ferroelectric cannot be effectively utilized.

One of the most important three-terminal superconducting devices is a field effect transistor type superconducting device (abbreviated as super-FET hereinafter) having a channel of a superconductor formed between a source and a drain. In this superconducting device, a current flowing through the superconducting channel is controlled by a signal voltage applied to a gate electrode formed on a gate insulator layer deposited on the superconducting channel. If the above ferroelectric having the dielectric constant dependent to temperature is used for the gate insulator layer of the super-FET, an electric field actually exerted on the superconducting channel has temperature dependence. Since, the signal voltage applied to the gate electrode of the super FET is divided into electric fields exerted on the superconducting channel and on the gate insulator layer according to the ratio of their dielectric constants. This means that the input-output properties of the super-FET has temperature dependence.

Some of these temperature dependence may be compensated by proper feedback loops or elementary devices having a temperature dependence complimentary to that of the ferroelectric. However, even in this case, if the circuits become complicated by the feedback loops or the elementary devices are complex, the operation speeds of the whole devices or circuits may decrease and their power consumption may increase. This spoils the features of the superconducting device such as high operation speed and low power consumption. Therefore, even if it is unavoidable that the properties of the superconducting device have temperature dependence, it is preferable that the temperature dependence is as simple as possible. For this purpose, it is necessary that proper temperature dependence can be set on the properties of the ferroelectric.

### Summary of the Invention

Accordingly, it is an object of the present invention to provide an insulator film having a novel configuration, which has overcome the above mentioned defects of the conventional ones.

The above and other objects of the present invention are achieved in accordance with the present invention by an oxide insulator film having a layered structure comprising at least two layers formed of oxide insulators having temperature properties different from each other.

According to another aspect of the present invention, there is provided an oxide insulator film having a layered structure compnsing at least two layers formed of oxide insulators having insulating properties different from each other.

The oxide insulator layers of the oxide insulator film of the present invention can comprise at least one ferroelectric layer. The ferroelectric material preferably selected from SrTiO₃, BaₓSr₁₋ₓTiO₃ (0 ≤ x < 1, abbreviated BSTO hereinafter) and Pb(Zr_{y}Ti_{1-y})O₃ (0 ≤ y < 1, abbreviated PZT hereinafter).

The oxide insulator layers may comprise at least two different BaₓSr₁₋ₓTiO₃ (0 ≤ x < 1) layers of which x have different values. The oxide insulator layers may also comprise at least one BaₓSr₁₋ₓTiO₃ (0 ≤ x < 1) layer of which x varies continuously.

The oxide insulator film of the present invention can utilized for a superconducting device comprising a layer formed of an oxide superconductor.

### Brief Description of the Drawings

Figure 1 shows graphs of dielectric constants (relative permittivities) of the STO films having thickness of 62, 125 and 250 nanometers against temperatures;
Figure 2 shows a sectional view of an embodiment of the insulator film in accordance with the present invention;
Figure 3 shows graphs of dielectric constants (relative permittivities) of the insulator films in accordance with the present invention and the prior art against temperatures;
Figure 4 shows a sectional view of a super-FET utilizing the insulator film in accordance with the present invention;
Figure 5 shows a second embodiment of the insulator film in accordance with the present invention;
Figure 6 shows a sectional view of a super-FET utilizing the insulator film of Figure 5 in accordance with the present invention;
Figure 7 shows a third embodiment of the insulator film in accordance with the present invention;
Figure 8 shows a sectional view of a super-FET utilizing the insulator film of Figure 7 in accordance with the present invention;
Figure 9A is a plan view showing a superconducting inductor utilizing the insulator film in accordance with the present invention;
Figure 9B is a diagrammatic sectional view of the superconducting inductor, shown in Figure 9A;
Figure 10A is a plane sectional view showing a superconducting capacitor utilizing the insulator film in accordance with the present invention; and
Figure 10B is a diagrammatic sectional view of the superconducting capacitor, shown in Figure 10A.

### Description of the Preferred embodiments

Oxide insulator films of layered structure according to the invention and oxide insulator films of a single layer according to the prior art were formed and their properties were measured to compare with each other.

### Embodiment 1

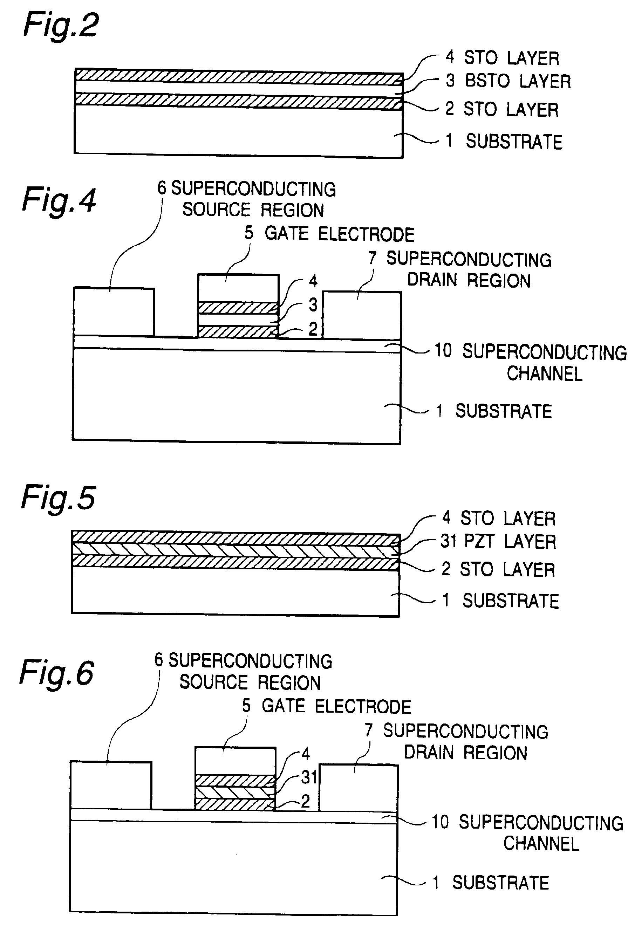

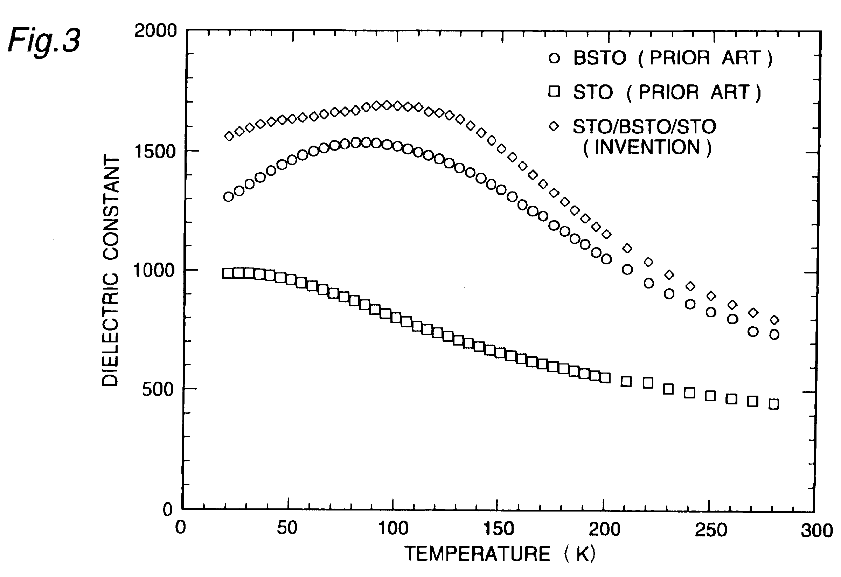

Referring to Figures 2 to 4, a first embodiment of the insulator film according to the present invention will be explained. Figure 2 shows a sectional view of a first embodiment of the insulator film in accordance with the present invention. The insulator film comprises a first STO layer 2, a BSTO (Ba_{0.15}Sr_{0.85}TiO₃) layer 3 and a second STO layer 4 each having a thickness of 114 nanometers which are stacked in the named order on a STO substrate 1. The ferroelectric layers were successively deposited by pulsed laser deposition to form the insulator film. A main deposition condition common to all the layers was as follows:

| | |
|---|---|
| Oxygen pressure | 3.999 Pa (0.03 Torr) |
| Substrate Temperature | 600 °C |

For comparison, an STO film having a thickness of 300 nanometers and a BSTO (Ba_{0.15}Sr_{0.85}TiO₃) film having a thickness of 300 nanometers were deposited on substrates by pulsed laser deposition to form insulator films of the prior art having a single ferroelectric layer. Main deposition conditions for the ferroelectric films were as follows:

| STO film | |
|---|---|
| Oxygen pressure | 3.999 Pa (0.03 Torr) |
| Substrate Temperature | 580 °C |

| BSTO film | |
|---|---|
| Oxygen pressure | 3.999 Pa (0.03 Torr) |
| Substrate Temperature | 600 °C |

Figure 3 shows graphs of dielectric constants (relative permittivities) of the oxide insulator film of layered structure according to the invention and oxide insulator films of a single layer according to the prior art against temperatures. Blank rhombi show dielectric constants of the oxide insulator film of layered structure according to the invention, blank circles show dielectric constants of the insulator film of a single BSTO layer and blank squares show dielectric constants of the insulator film of a single STO layer. As shown in Figure 3, the insulator film according to the invention had an almost fixed dielectric constant of around 1600 at a temperature range of 40 K to 120 K, which was stable at a temperature range wider than those of the insulator films of a single layer of the prior art.

The breakdown voltage of the insulator film according to the invention was measured 3 × 10⁶ volts/centimeters, however, the breakdown voltage of the insulator film of a single STO film having a thickness of 400 nanometers, which is thicker than the insulator film according to the invention, was measured 1 × 10⁶ volts/centimeters.

Figure 4 shows a sectional view of a super-FET utilizing the insulator film of layered structure according to the invention as a gate insulator layer. The super-FET shown in Figure 4 comprises a substrate 1 of, for example, SrTiO₃, a superconducting channel 10 of an oxide superconductor, for example, Y₁Ba₂Cu₃O₇₋ₓ disposed on the substrate 1, a superconducting source region 6 and a superconducting drain region 7 of Y₁Ba₂Cu₃O₇₋ₓ disposed at each end of the superconducting channel 10. The super-FET further comprises a gate electrode 5 on a gate insulator formed of a first STO layer 2, a BSTO layer 3 and a second STO layer 4 disposed on the superconducting channel 10.

The superconducting source region 6 and superconducting drain region 7 can be formed of an oxide superconductor different from that of the superconducting channel 10. The gate electrode 4 can be formed of a noble metal such as Pt, Ag, Au.

In the super-FET, superconducting current flowing through the superconducting channel 10 is controlled by a signal voltage applied to the gate electrode 5. The Y₁Ba₂Cu₃O₇₋ₓ oxide superconductor has a carrier density of 10²⁰-10²¹/cm³, so that both of the superconducting channel should have an extremely thin thickness to obtain a complete ON/OFF operation by a signal voltage of a few volts, which is usually used for CMOS semiconductor devices, applied to the gate electrode 5. For example, the superconducting channel should have a thickness of five nanometers or less.

The super-FET shown in Figure 4 comprises a gate insulator layer formed of the insulating film according to the invention. Therefore, it has stable and excellent properties at a wider temperature range.

### Embodiment 2

Referring to Figures 5 and 6, a second embodiment of the insulator film according to the present invention will be explained. Figure 5 shows a sectional view of a second embodiment of the insulator film in accordance with the present invention. The insulator film comprises a first STO layer 2, a PZT (Pb(Zr_{0.5}Ti_{0.5})O₃) layer 31 and a second STO layer 4 each having a thickness of 114 nanometers which are stacked in the named order on a STO substrate 1. The ferroelectric layers were successively deposited in the named order on the substrate 1 by pulsed laser deposition to form an insulator film according to the invention. A main deposition condition common to all the layers was as follows:

| STO layer | |
|---|---|
| Oxygen pressure | 3.999 Pa (0.03 Torr) |
| Substrate Temperature | 600 °C |

| PZT layer | |
|---|---|
| Oxygen pressure | 2.666 Pa (0.02 Torr) |
| Substrate Temperature | 550 °C |

The insulator film according to the invention had an almost fixed dielectric constant of around 1400 at a temperature range of 40 K to 140 K, which was stable at a temperature range wider than those of the insulator films of a single layer of the prior art.

The breakdown voltage of the insulator film according to the invention was measured 2 × 10⁶ volts/centimeters.

Figure 6 shows a sectional view of a super-FET utilizing the insulator film of layered structure according to the invention as a gate insulator layer. The super-FET shown in Figure 6 comprises a substrate 1 of, for example, SrTiO₃, a superconducting channel 10 of an oxide superconductor, for example, Y₁Ba₂Cu₃O₇₋ₓ disposed on the substrate 1, a superconducting source region 6 and a superconducting drain region 7 of Y₁Ba₂Cu₃O₇₋ₓ disposed at each end of the superconducting channel 10. The super-FET further comprises a gate electrode 5 on a gate insulator formed of a first STO layer 2, a PZT layer 31 and a second STO layer 4 disposed on the superconducting channel 10.

The other parts of the super-FET is equal to those of the super-FET shown in Figure 4. Therefore, descriptions are left out to avoid duplication.

The super-FET shown in Figure 6 comprises a gate insulator layer formed of the insulating film according to the invention. Therefore, it has stable and excellent properties at a wider temperature range.

### Embodiment 3

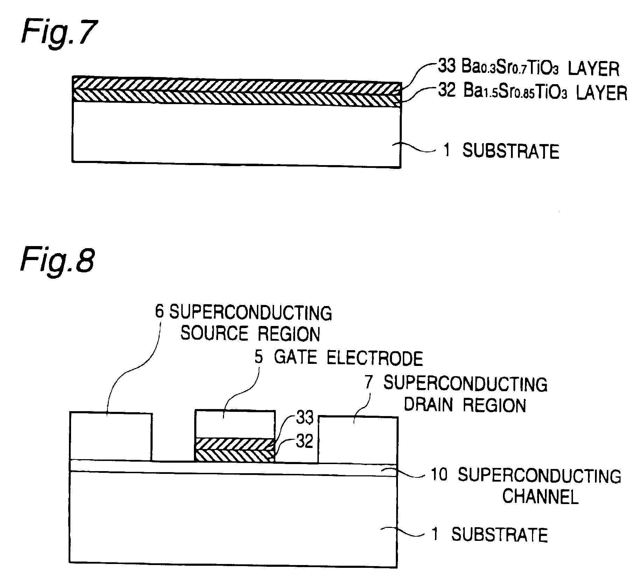

Referring to Figures 7 and 8, a third embodiment of the insulator film according to the present invention will be explained. Figure 7 shows a sectional view of a third embodiment of the insulator film in accordance with the present invention. The insulator film comprises a first BSTO layer 32 having a composition of Ba_{0.15}Sr_{0.85}TiO₃ and a second BSTO layer 33 having a composition of Ba_{0.3}Sr_{0.7}TiO₃. Each of the ferroelectric layers has a thickness of 200 nanometers and are stacked in the named order on a STO substrate 1. The BSTO layers were successively deposited in the named order on the substrate 1 by pulsed laser deposition to form an insulator film according to the invention. A main deposition condition common to the two layers was as follows:

| | |
|---|---|
| Oxygen pressure | 3.999 Pa (0.03 Torr) |
| Substrate Temperature | 600 °C |

The insulator film according to the invention had an almost fixed dielectric constant of around 1500 at a temperature range of 80 K to 160 K, which was stable at a temperature range wider than those of the insulator films of a single layer of the prior art.

Figure 8 shows a sectional view of a super-FET utilizing the insulator film of layered structure according to the invention as a gate insulator layer. The super-FET shown in Figure 8 comprises a substrate 1 of, for example, SrTiO₃, a superconducting channel 10 of an oxide superconductor, for example, Y₁Ba₂Cu₃O₇₋ₓ disposed on the substrate 1, a superconducting source region 6 and a superconducting drain region 7 of Y₁Ba₂Cu₃O₇₋ₓ disposed at each end of the superconducting channel 10. The super-FET further comprises a gate electrode 5 on a gate insulator formed of a first BSTO layer 32 and a second BSTO layer 33 disposed on the superconducting channel 10.

The other parts of the super-FET is equal to those of the super-FETs shown in Figures 4 and 6. Therefore, descriptions are left out to avoid duplication.

The super-FET shown in Figure 8 comprises a gate insulator layer formed of the insulating film according to the invention. Therefore, it has stable and excellent properties at a wider temperature range.

### Embodiment 4

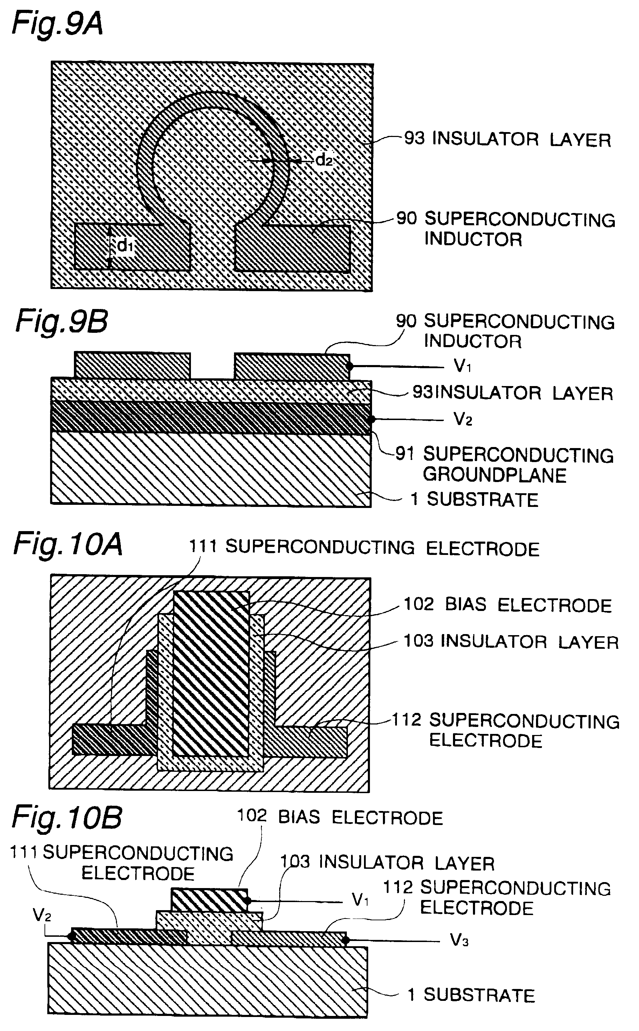

Referring to Figures 9A and 9B, there is shown a diagrammatic plane view and sectional view showing a superconducting inductor utilizing the insulator film in accordance with the present invention. This superconducting inductor has a structure similar to the one described in U. S. Patent No. 5,604,375.

The shown superconducting inductor comprises a substrate 1 formed of LaAlO₃, a superconducting groundplane 91 of a Y₁Ba₂Cu₃O₇₋ₓ oxide superconductor and an insulator layer 93 of the insulator film in accordance with the present invention stacked in the named order on the substrate 1. On the insulator layer 93, a superconducting inductor of an Ω-shaped Y₁Ba₂Cu₃O₇₋ₓ oxide superconductor thin film is arranged.

The first superconducting groundplane 91 has a thickness of 500 nanometers. The insulator layer 93 has a thickness of 800 nanometers.

A first embodiment of the superconducting inductor has an insulator layer 93 formed of a first STO layer having a thickness of 300 nanometers, a BSTO layer having a thickness of 200 nanometers and a second STO layer having a thickness of 200 nanometers.

A second embodiment of the superconducting inductor has an insulator layer 93 formed of a first STO layer having a thickness of 300 nanometers, a PZT layer having a thickness of 200 nanometers and a second STO layer having a thickness of 200 nanometers.

A third embodiment of the superconducting inductor has an insulator layer 93 formed of two BSTO layers each having a thickness of 400 nanometers, and a first BSTO layer having a composition of Ba_{0.15}Sr_{0.85}TiO₃ and a second BSTO layer having a composition of Ba_{0.3}Sr_{0.7}TiO.

The superconducting inductor 90 have a thickness of 200 nanometers. The straight portion of the inductor 90 has a width d₁ of 0.1 millimeters, and the circular portion of the inductor 90 has a width d₂ of 0.01 millimeters and a diameter of 0.4 millimeters with a gap of 0.02 millimeters.

Either the groundplane 91 or the inductor 90 can be formed of an oxide superconductor with opposite polarity of the charge carriers such as electron carrier type Nd-Ce-Cu-O (Y₁Ba₂Cu₃O₇₋ₓ is a hole-carrier type superconductor). In this case, the response is influenced by all the changes in the inductor 90, the insulator layer 93 and the ground plane 91 in a comparable fashion

In addition, actually, conducting wires such as gold wires with appropriate microwave filters (not shown) are provided at the groundplane 91 and the superconducting inductor 90 in order to apply dc bias voltages V₁ and V₂.

By applying dc bias voltages V₁ and V₂ to the groundplane 91 and the superconducting inductor 90, conductivity of the Y₁Ba₂Cu₃O₇₋ₓ oxide superconductor of the groundplane 11 and the superconducting inductor 12 and the dielectric property of the insulator layer 93 are changed so that the inductance and overall microwave resistance of the superconducting inductor vary.

The superconducting inductor shown in Figures 9A and 9B comprises an insulator layer formed of the insulating film according to the invention. Therefore, it has stable and excellent properties at a wider temperature range.

### Embodiment 5

Figures 10 and 10B show a plane view and a sectional view of a superconducting capacitor utilizing the insulator film in accordance with the present invention. This superconducting capacitor has a structure similar to the one described in U. S. Patent No. 5,604,375.

The superconducting capacitor comprises a substrate 1 formed of LaAlO₃, a first and a second superconducting electrodes 111 and 112 of L-shaped Y₁Ba₂Cu₃O₇₋ₓ oxide superconductor thin films formed on the substrate 1 separated from each other, an insulator layer 103 of the insulator film in accordance with the present invention stacked on the superconducting electrodes 111 and 112 and a bias electrode 102 stacked on the insulator layer. The first and second superconducting electrodes 111 and 112 are formed of a symmetrically patterned Y₁Ba₂Cu₃O₇₋ₓ oxide superconductor thin films and have a thickness of 300 nanometers, a width of 0.01 millimeters, a dimension of 0.1 × 0.1 millimeters and a gap of 0.01 millimeters, and the insulator layer 103 has a thickness of 400 nanometers and a dimension of 0.1 × 0.2 millimeters. The bias electrode 102 has a thickness of 100 nanometers. The bias electrode 102 does not need to be a superconducting electrode so that a normal metal such as Au, Ag or Pt can be used.

However, the bias electrode 102 can be a superconducting electrode with opposite polarity of the charge carriers such as electron carrier type Nd-Ce-Cu-O (Y₁Ba₂Cu₃O₇₋ₓ is a hole-carrier type superconductor). In this case, the response is influenced by all the changes in the superconducting electrodes 111 and 112, the insulator layer 103 and the bias electrode 102 in a comparable fashion

In addition, actually, conducting wires such as gold wires (not shown) with appropriate microwave filtering elements are provided on the first and second superconducting electrode 111 and 112 and the bias electrode 102 in order to apply dc bias voltages V₁, V₂ and V₃.

A first embodiment of the superconducting capacitor has an insulator layer 103 formed of a first STO layer having a thickness of 100 nanometers, a BSTO layer having a thickness of 200 nanometers and a second STO layer having a thickness of 100 nanometers.

A second embodiment of the superconducting capacitor has an insulator layer 103 formed of a first STO layer having a thickness of 100 nanometers, a PZT layer having a thickness of 200 nanometers and a second STO layer having a thickness of 100 nanometers.

A third embodiment of the superconducting capacitor has an insulator layer 103 formed of two BSTO layers each having a thickness of 200 nanometers, and a first BSTO layer having a composition of Ba_{0.15}Sr_{0.85}TiO₃ and a second BSTO layer having a composition of Ba_{0.3}Sr_{0.7}TiO.

The superconducting capacitor shown in Figures 10A and 10B comprises an insulator layer formed of the insulating film according to the invention. Therefore, it has stable and excellent properties at a wider temperature range.

Each layer of the insulator film according to the invention should have a sufficient thickness such that its electric properties are not affected by distortions of the layers. -The thickness of each layer and the number of the layers can be determined by the required thickness of the insulator film and the temperature range where the insulator film is used. In general, each layer of the insulator film according to the invention has a thickness of from a few tens to 200 nanometers and several layers are included in one insulator film according to the invention.

As explained above, the oxide insulator film of layered structure according to the invention has an almost fixed dielectric constant at a wide temperature range wider, which was stable at a temperature range wider than those of the insulator films of a single layer of the prior art. In addition, it is possible to set dielectric properties such as insulating properties other than the temperature dependence to specific values. Furthermore, the oxide insulator film of layered structure according to the invention improves breakdown voltage of the superconducting device and prevents inter-layer diffusion. It is possible to design overall electric properties of the layered structure of oxide superconductor layer and insulator layer by utilizing the oxide insulator film of layered structure according to the invention.

The invention has thus been shown and described with reference to the specific embodiments. However, it should be noted that the present invention is in no way limited to the details of the illustrated structures but converts and modifications may be made within the scope of the appended claims.

The entire disclosures of Japanese Patent Applications Nos. 8-337573 filed on December 3, 1996 and 9-49706 filed on February 18, 1997 including specifications, claims, drawings and summaries are incorporated herein by reference in its entirety.

## Claims

1. An oxide insulator film having a layered structure comprising at least two layers formed of oxide insulators having temperature properties different from each other.

2. An oxide insulator film as claimed in Claim 1; wherein the oxide insulator layers comprise at least one ferroelectric layer.

3. An oxide insulator film as claimed in Claim 2; wherein the oxide insulator layers comprise at least one layer formed of a ferroelectric material selected from the group consisting of SrTiO₃, BaₓSr₁₋ₓTiO₃ (0 ≤ x < 1) and Pb(Zr_{y}Ti_{1-y})O₃ (0 ≤ y < 1).

4. An oxide insulator film as claimed in Claim 2; wherein the oxide insulator layers comprise at least two different BaₓSr₁₋ₓTiO₃ (0 ≤ x < 1) layers of which x have different values.

5. An oxide insulator film as claimed in Claim 2; wherein the oxide insulator layers comprise at least one BaₓSr₁₋ₓTiO₃ (0 ≤ x < 1) layer of which x varies continuously.

6. A superconducting device comprising a layer formed of an oxide superconductor; wherein the device comprises an oxide insulator film as claimed in Claim 1.

7. A superconducting device as claimed in Claim 6; wherein the superconducting device is a super-FET.

8. A superconducting device as claimed in Claim 6; wherein the superconducting device is a superconducting microwave device.

9. A superconducting device as claimed in Claim 8; wherein the superconducting device is a superconducting inductor.

10. A superconducting device as claimed in Claim 8; wherein the superconducting device is a superconducting capacitor.

11. An oxide insulator film having a layered structure comprising at least two layers formed of oxide insulators having insulating properties different from each other.

12. An oxide insulator film as claimed in Claim 11; wherein the oxide insulator layers comprise at least one ferroelectric layer.

13. An oxide insulator film as claimed in Claim 12; wherein the oxide insulator layers comprise at least one layer formed of a ferroelectric material selected from the group consisting of SrTiO₃, BaₓSr₁₋ₓTiO₃ (0 ≤ x < 1) and Pb(Zr_{y}Ti_{1-y})O₃ (0 ≤ y < 1).

14. An oxide insulator film as claimed in Claim 12; wherein the oxide insulator layers comprise at least two different BaₓSr₁₋ₓTiO₃ (0 ≤ x < 1) layers of which x have different values.

15. An oxide insulator film as claimed in Claim 12; wherein the oxide insulator layers comprise at least one BaₓSr₁₋ₓTiO₃ (0 ≤ x < 1) layer of which x varies continuously.

16. A superconducting device comprising a layer formed of an oxide superconductor; wherein the device comprises an oxide insulator film as claimed in Claim 11.

17. A superconducting device as claimed in Claim 16; wherein the superconducting device is a super-FET.

18. A superconducting device as claimed in Claim 16; wherein the superconducting device is a superconducting microwave device.

19. A superconducting device as claimed in Claim 18; wherein the superconducting device is a superconducting inductor.

20. A superconducting device as claimed in Claim 18; wherein the superconducting device is a superconducting capacitor.
